# EUROPEAN PATENT APPLICATION

(11) **EP 1 050 960 A2**
(43) Date of publication of application: **08.11.2000**
(21) Application number: 00401251.4
(22) Date of filing: 05.05.2000
(51) Int. Cl.: H03H 7/01

(54) **Laminated LC filter**

(30) Priority: 07.05.1999 JP 12781899
(71) Applicant: Murata Manufacturing Co., Ltd., Nagaokakyo-shi Kyoto-fu 617-8555 (JP)
(72) Inventor: Kato, Noboru, c/o Murata Manufacturing CO., Ltd., Nagaokakyo-shi, Kyoto-fu 617-8555 (JP)
(74) Representative: Thévenet, Jean-Bruno

(57) **Abstract**

The present invention provides a laminated LC filter (51) in which the inductance of the LC resonator is large, and having an excellent Q characteristic. The inductor patterns (54a,b/55a,b) are in identical shapes, laminated through the insulation sheets (52), and constitute respective inductors (L1/L2) having duplex structure. Capacitor patterns (58a,b/59a,b) are opposite to enlarged parts (56a,b/57a,b) of the inductor patterns, and form respective capacitors. A coupling capacitor pattern (62) is located between the inductor patterns (54a,b;55a,b).

## Description

### BACKGROUND OF THE INVENTION

### 1. Field of the Invention

The present invention relates to a LC filter, and more particularly to a laminated LC filter that is used at high frequencies.

### 2. Description of the Related Art

Below, references to specific directions (e.g. «front», «back», «left» and «right») refer to the devices when oriented as shown in the respective figures.

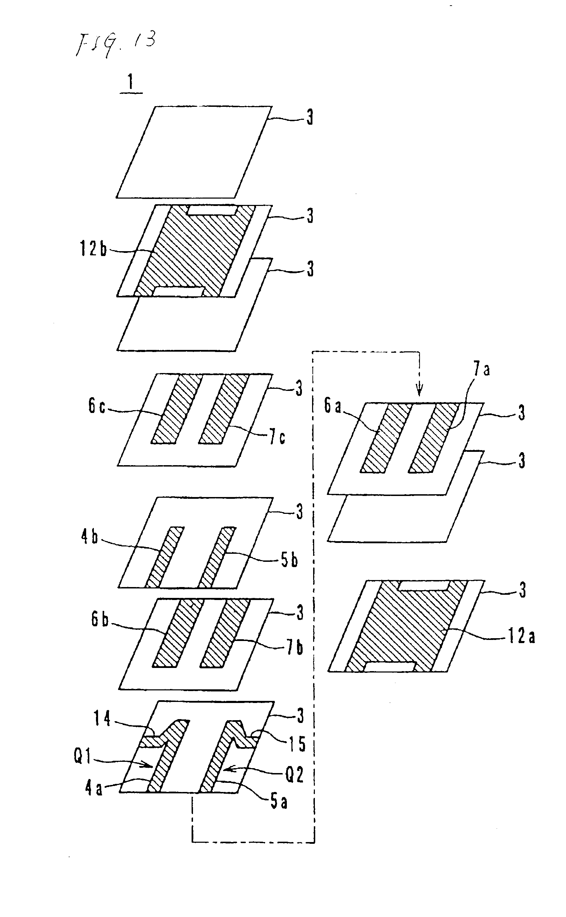

In general, a band pass filter that passes a signal of a specific frequency band includes a plurality of LC resonators. A concrete configuration of one example of a conventional band pass filter is shown in Fig. 13. As shown in Fig. 13, the band pass filter 1 is one that includes LC resonators Q1, Q2 of the first and the second stages, within the laminate body constituted by piling up ceramic sheets 3.

The inductances of the LC resonators Q1, Q2 are formed respectively by the inductor patterns 4a, 4b, 5a, 5b. The capacitances of the LC resonators Q1, Q2 are formed respectively by the capacitor patterns 6a to 6c, 7a to 7c, and the inductor patterns 4a, 4b, 5a, 5b that are opposite to these capacitor patterns 6a to 6c, 7a to 7c through the ceramic sheets 3. The above described LC resonators Q1, Q2 are mutually coupled electromagnetically.

A leading edge of the inductor pattern 4a is connected to an input lead pattern 14 that is provided on a left side of the sheet 3. A leading edge of the inductor pattern 5a is connected to an output lead pattern 15 that is provided on a right side of the sheet 3. Then, the shielding patterns 12a, 12b are arranged by sandwiching the inductor patterns 4a, 4b, 5a, 5b and the capacitor patterns 6a to 6c, 7a to 7c that are arranged alternately.

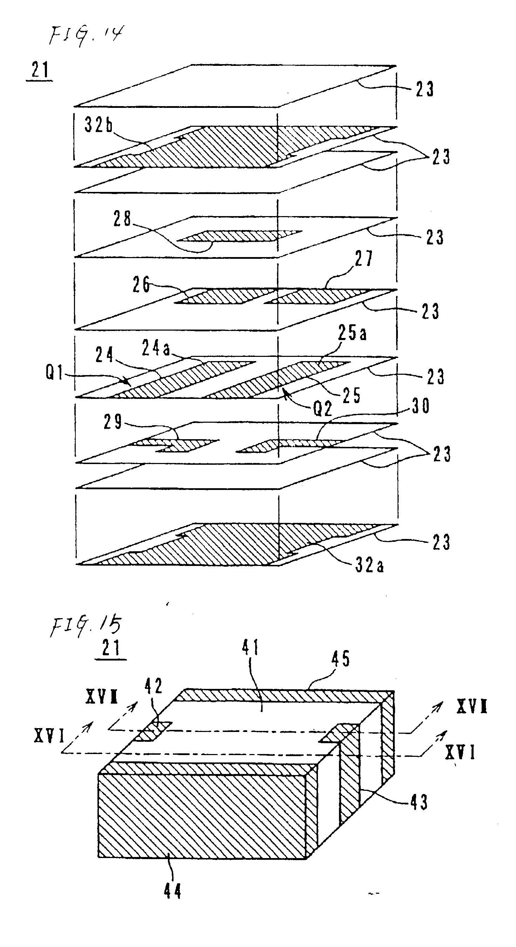

As another example of the conventional laminated band pass filter, there also exists the one with a configuration shown in Figs. 14 and 15. This band pass filter 21 is one that includes LC resonators Q1, Q2 of the first and the second stages, within a laminate body 41 constituted by piling up ceramic sheets 23.

The inductances of the LC resonators Q1, Q2 are formed respectively by inductor patterns 24, 25. The capacitances of the LC resonators Q1, Q2 are formed respectively by capacitor patterns 26, 27, and the leading edges 24a, 25a of the inductor patterns 24, 25 that are opposite to these capacitor patterns 26, 27. The above described LC resonators Q1, Q2 are coupled electrically by a coupling capacitor that is formed by these inductor patterns 24, 25 and a coupling capacitor pattern 28 that is opposite to these inductor patterns 24, 25. These LC resonators Q1, Q2 are capacitive-coupled respectively to an input lead pattern 29 and an output lead pattern 30. Then, shielding patterns 32a, 32b are arranged by sandwiching these patterns 24 to 30.

In the laminated body 41, an input terminal electrode 42, an output terminal electrode 43 and shielding terminal electrodes 44, 45 such as shown in Fig. 15 are formed. The input lead pattern 29 is connected to the input terminal electrode 42, the output lead pattern 30 is connected to the output terminal electrode 43. The lead parts of the inductor patterns 24, 25 and the one end parts of the shielding patterns 32a, 32b are connected to the shielding terminal electrode 44. The lead parts of the capacitor patterns 26, 27 and the other end parts of the shielding patterns 32a, 32b are connected to the shielding terminal electrode 45.

However, in the case of the band pass filter 1 as shown in Fig. 13, it is laminated in a state in which the inductor patterns 4a to 5b are sandwiched by the capacitor patterns 6a to 6c, 7a to 7c, so that electric currents flow into each of the inductor patterns 4a to 5b from two capacitor patterns arranged on both sides. Accordingly, there exists a problem such that an amount of electric current (a current density) flowing through the inductor patterns 4a to 5b increases, and thus the Q characteristics of the LC resonators Q1, Q2 are relatively poor.

Further, in the case of the band pass filter 21 as shown in Figs. 14 and 15, the magnetic field H generated in the surroundings of the inductor patterns 24, 25 does not utilize the area S enclosed by a dotted line in Fig. 16 as a magnetic path, effectively. As a result, the inductances of the LC resonators Q1, Q2 are small. In addition, because the magnetic field H is concentrated at the edges of the inductor patterns 24, 25, an eddy current loss is large, and thus the Q characteristics are poor. Moreover, as shown in Fig. 17, the magnetic field H generated in the surroundings of the inductor patterns 24, 25 is blocked by the coupling capacitor pattern 28 and the input/output lead patterns 29, 30. Accordingly, the inductances of the LC resonators Q1, Q2 are also reduced for the above-described reason.

### SUMMARY OF THE INVENTION

Accordingly, it is an object of the present invention to provide a laminated LC filter having a large inductance of the LC resonator, and an excellent Q characteristic.

The object of the present invention can be achieved by a laminated LC filter, which includes a laminated body formed by stacking a plurality of insulation layers, a plurality of inductor patterns, and a plurality of capacitor patterns, and a plurality of LC resonators constituted of a plurality of inductors formed by the inductor patterns, and a plurality of capacitors in which the capacitor patterns are formed to be opposite to the inductor patterns, at the inside of the laminated body, wherein the inductor of each LC resonator is made as a multiplex structure by laminating two or more of the inductor patterns in approximately identical shapes via the insulation layers, and coupling capacitor patterns for capacitive-coupling between the LC resonators are laminated between the inductor patterns of the inductors.

Preferably, capacitor patterns for input/output are laminated between the inductor patterns of the inductors.

More preferably, three or more stages of filters are constituted by connecting at least three of the LC resonators, and the pattern widths of the inductor patterns forming the LC resonators located at other than both ends are made wider than the pattern widths of the inductor patterns forming the LC resonators located at both ends.

Further preferably, patterns for a pole adjustment are laminated between the inductor patterns of the inductors.

With the above-described configuration, no magnetic field is generated between two or more of the inductor patterns in approximately identical shapes that constitute the respective inductors, and coupling capacitor patterns and/or capacitor patterns for input/output that are arranged between the inductor patterns hardly block the magnetic field of the inductors.

Also, by making the inductor as the multiplex structure, it relaxes the magnetic field generated in the surroundings of the inductor to be concentrated at the edge of the inductor patterns. Moreover, it arises that the inductor patterns in the respective LC resonators correspond to the capacitor patterns at least one-to-one, and the amount of electric current flowing into the respective inductor patterns from the capacitor patterns becomes smaller than in conventional devices. Accordingly, the current density flowing through the inductor patterns is reduced, and the Q characteristic of the respective LC resonators is enhanced.

Further, in the laminated LC filter according to preferred embodiments of the present invention, three or more stages of filters are constituted by connecting at least three of the LC resonators, and the pattern widths of the inductor patterns forming the LC resonators located at other than both ends are made wider than the pattern widths of the inductor patterns forming the LC resonators located at both ends. Usually, the magnetic field concentration at the edge of the inductor patterns (for the inductor patterns that constitute the LC resonators located at other than both ends) is larger as compared to the one for the inductor patterns forming the LC resonators located at both ends. By making the pattern widths of the inductor patterns of the LC resonator located at other than both ends to be wider, it enables to relax the magnetic field at the edges of the inductor patterns.

Moreover, by laminating the patterns for a pole adjustment between the inductor patterns of the inductors, it enables the pole position in the filter characteristic to be set freely, without blocking the magnetic field generated in the surroundings of the inductors.

### BRIEF DESCRIPTION OF THE DRAWINGS

Further objects and advantages of the invention can be more fully understood from the following detailed description of preferred embodiments thereof, given by way of example, taken in conjunction with the accompanying drawings in which:

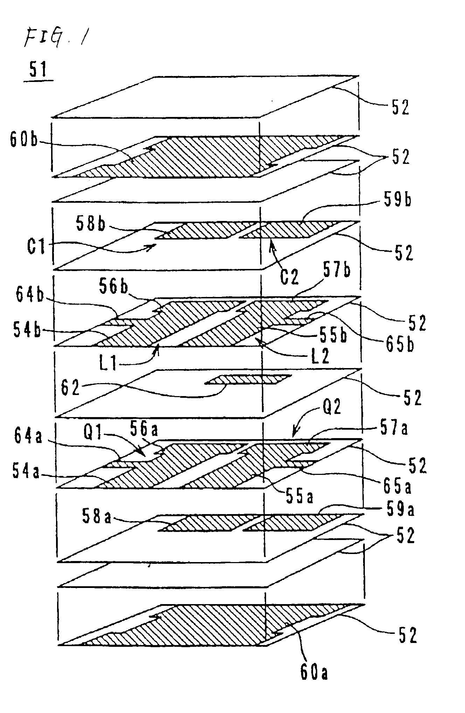

Fig. 1 is an exploded perspective view showing a structure of the first embodiment of the laminated LC filter according to the present invention;

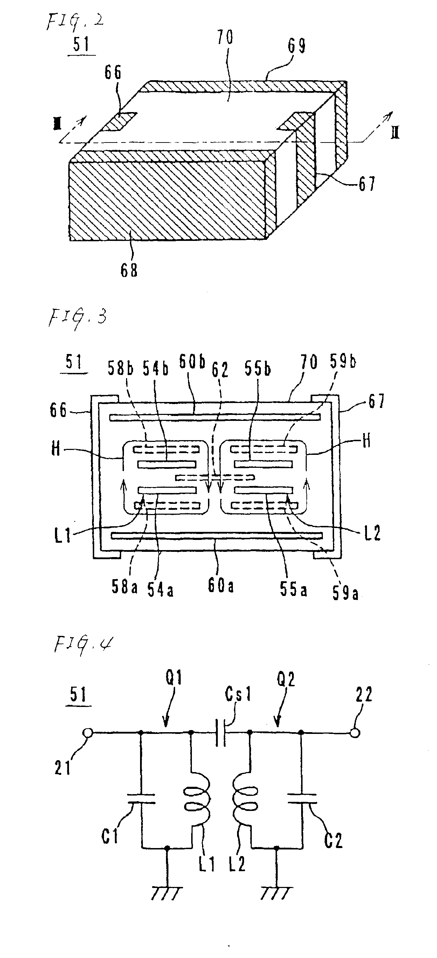

Fig. 2 is a perspective view of the appearance of the laminated LC filter shown in Fig. 1;
Fig. 3 is a schematic diagram showing a state of a magnetic field as seen from III - III in Fig. 2;

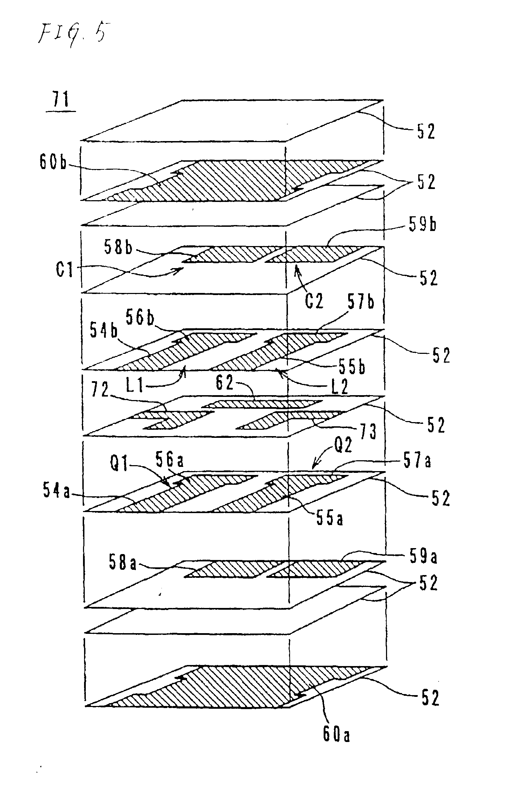

Fig. 4 is an electrical equivalent circuit diagram of the laminated LC filter shown in Fig. 2;
Fig. 5 is an exploded perspective view showing a structure of the second embodiment of the laminated LC filter according to the present invention;

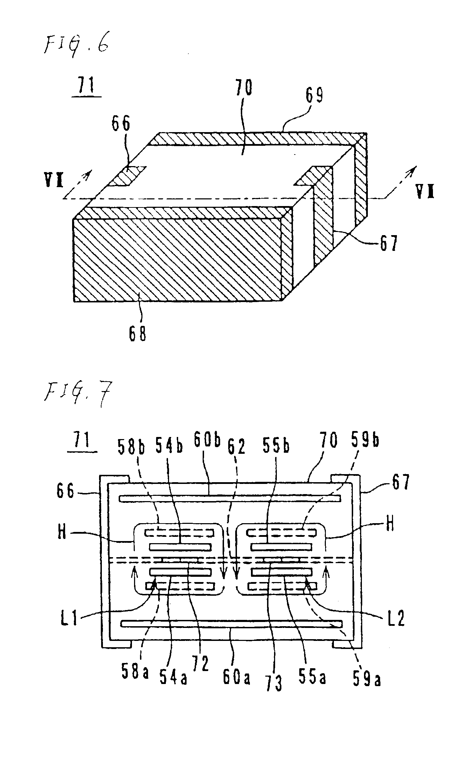

Fig. 6 is a perspective view of the appearance of the laminated LC filter shown in Fig. 5;
Fig. 7 is a schematic diagram showing a state of a magnetic field as seen from VII - VII in Fig. 6;

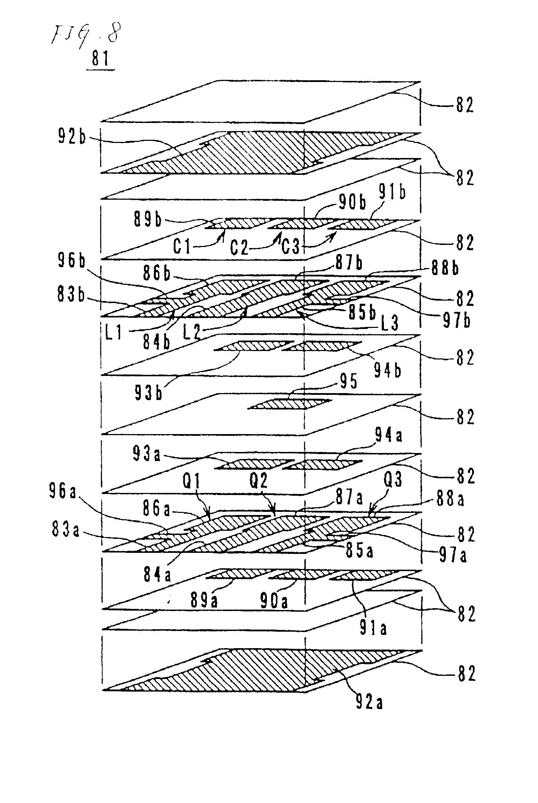

Fig. 8 is an exploded perspective view showing a structure of the third embodiment of the laminated LC filter according to the present invention;

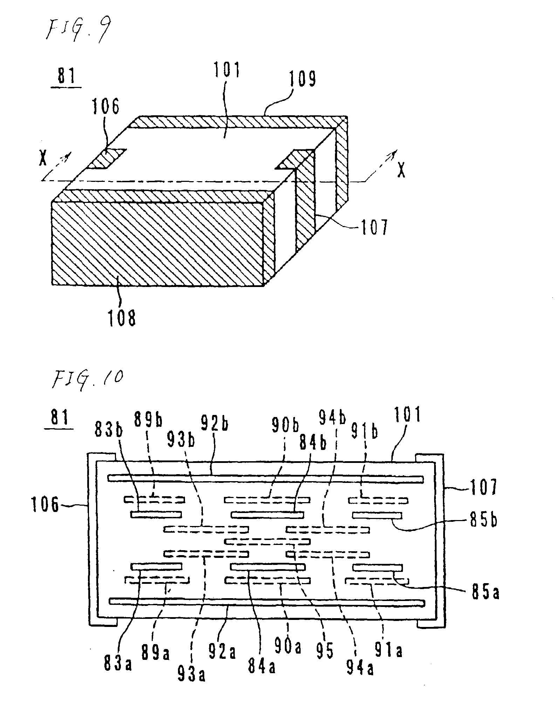

Fig. 9 is a perspective view of the appearance of the laminated LC filter shown in Fig. 8;
Fig. 10 is a schematic diagram showing a state of a magnetic field as seen from X - X in Fig. 9;
Fig. 11 is an electrical equivalent circuit diagram of the laminated LC filter shown in Fig. 9;

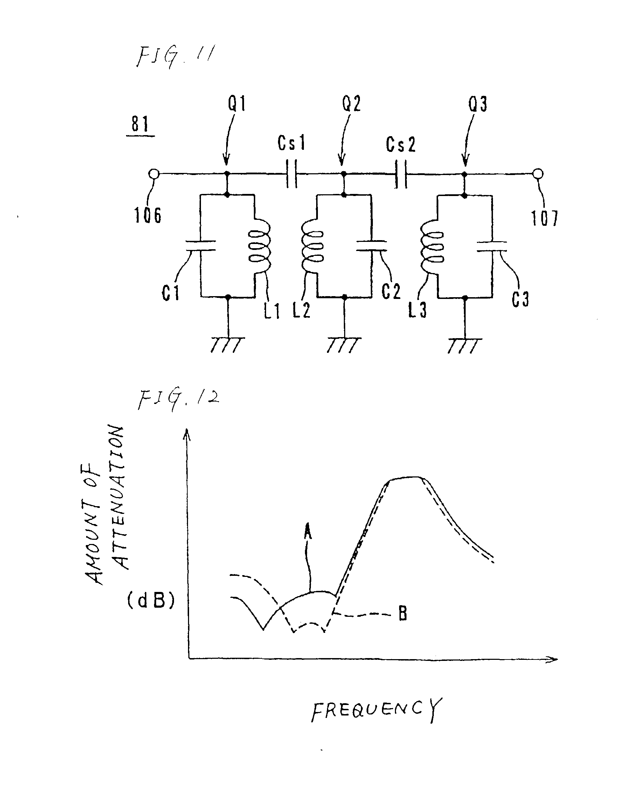

Fig. 12 is a graph showing an attenuation characteristic of the laminated LC filter shown in Fig. 9.
Fig. 13 is an exploded perspective view of a conventional laminated LC filter;
Fig. 14 is an exploded perspective view of another conventional laminated LC filter;
Fig. 15 is a perspective view of the appearance of the laminated LC filter shown in Fig. 14;

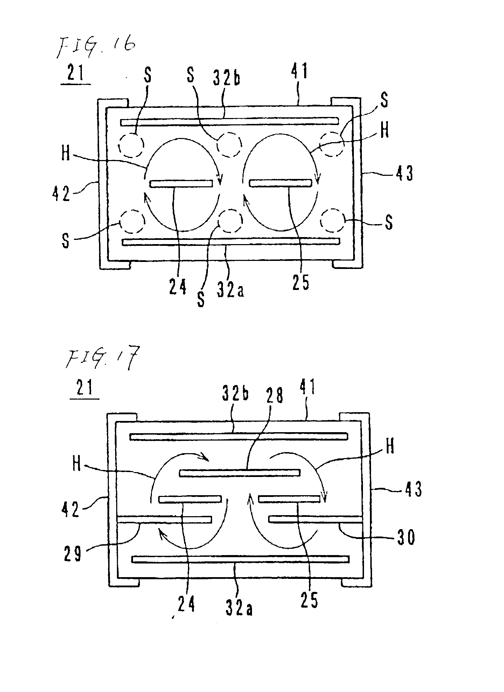

Fig. 16 is a schematic diagram showing a state of a magnetic field as seen from XVI - XVI in Fig. 15; and
Fig. 17 is a schematic diagram showing a state of a magnetic field as seen from XVII- XVII in Fig. 15.

### DESCRIPTION OF THE PREFERRED EMBODIMENT(S)

In the following, the preferred embodiments of the laminated LC filter according to the present invention will be described with reference to the accompanying drawings. Each embodiment describes the band pass filter as an example thereof, but it may be a band stop filter or the like.

### First Embodiment

A structure of the laminated LC band pass filter 51 is shown in Fig. 1, and a perspective view showing the appearnce, and an electrical equivalent circuit diagram, of the LC filter 51 are shown in Figs. 2 and 4, respectively. As shown in Fig. 4, the LC filter 51 is a two-stage LC band pass filter, and the LC resonator Q1 at the first stage and the LC resonator Q2 at the second stage are capacitive-coupled by the coupling capacitor Cs1.

As shown in Fig. 1, the LC filter 51 is constituted of two ceramic sheets 52 on the surface of which the inductor patterns 54a, 54b, 55a, 55b are provided, respectively, two ceramic sheets 52 on the surface of which the capacitor patterns 58a, 58b, 59a, 59b are provided, respectively, two ceramic sheets 52 on the surface of which the shielding patterns 60a, 60b are provided, respectively , and a ceramic sheet 52 on the surface of which the coupling capacitor pattern 62 is provided, and the like. The ceramic sheets 52 are square-shaped sheets made of a ceramic dielectric material such as a barium titanate or the like.

The inductor patterns 54a, 54b are in the same shape, and are laminated via the sheets 52, and constitute an inductor L1 of a duplex structure. The inductor patterns 54a, 54b that are formed at the left-side locations of the sheet 52 are such that one ends thereof are exposed at an edge at the front side of the sheet 52. The other ends 56a, 56b of the inductor patterns 54a, 54b are enlarged, and these enlarged parts 56a, 56b also function as the capacitor patterns. The input lead patterns 64a, 64b that extend respectively from the central parts of the inductor patterns 54a, 54b are exposed on a left side of the sheet 52.

The inductor patterns 55a, 55b are in the same shape, and are laminated through the sheets 52, and constitute an inductor L2 of a duplex structure. The inductor patterns 55a, 55b that are formed at the right-side locations of the sheet 52 are such that one ends thereof are exposed at an edge at the front side of the sheet 52. The other ends 57a, 57b of the inductor patterns 55a, 55b are enlarged, and these enlarged parts 57a, 57b also function as the capacitor patterns. The output lead patterns 65a, 65b that extend respectively from the central parts of the inductor patterns 55a, 55b are exposed on the right side of the sheet 52.

The capacitor patterns 58a, 58b are formed at the left-side locations of the respective sheets 52, and one ends thereof are exposed at an edge at the rear side of the sheet 52. In the stacking direction of the sheets 52, the inductor L1 of the duplex structure that is constituted of the inductor patterns 54a, 54b is arranged between the capacitor patterns 58a, 58b. These capacitor patterns 58a, 58b are opposite to the enlarged parts 56a, 56b of the inductor patterns 54a, 54b, and form the capacitor C1. Then, a LC parallel resonance circuit is formed by the capacitor C1 and the inductor L1 of the duplex structure, and constitutes the LC resonator Q1 of the first stage.

The capacitor patterns 59a, 59b are formed at the right-side locations of the respective sheets 52, and one ends thereof are exposed at an edge at the rear side of the sheet 52. In the stacking direction of the sheets 52, the inductor L2 of the duplex structure that is constituted of the inductor patterns 55a, 55b is arranged between the capacitor patterns 59a, 59b. These capacitor patterns 59a, 59b are opposite to the enlarged parts 57a, 57b of the inductor patterns 55a, 55b, and form the capacitor C2. Then, a LC parallel resonance circuit is formed by the capacitor C2 and the inductor L2 of the duplex structure, and constitutes the LC resonator Q2 of the second stage.

The coupling capacitor pattern 62 is provided at the central part at a rear side of the sheet 52, and in the stacking direction of the sheets 52, it is located between the inductor patterns 54a, 55a and the inductor patterns 54b, 55b. This coupling capacitor pattern 62 is opposite to the enlarged parts 56a, 56b, 57a, 57b, and forms the coupling capacitor Cs1. The shielding patterns 60a, 60b cover wide areas such that one ends thereof are exposed at an edge at the front side, and the other ends thereof are exposed at an edge at the rear side of the respective sheets 52.

Each sheet 52 configured as described above is stacked in sequence as shown in Fig. 1, and is made to be the laminated body 70 as shown in Fig. 2 by firing integrally. The input terminal electrode 66 and the output terminal electrode 67 are formed at the left and right ends of the laminated body 70, respectively, and the shielding electrodes 68, 69 are formed at the front and rear sides, respectively. The input lead patterns 64a, 64b are connected to the input terminal electrode 66, and the output lead patterns 65a, 65b are connected to the output terminal electrode 67. One ends of the inductor patterns 54a, 54b, 55a, 55b and one ends of the shielding patterns 60a, 60b are connected to the shielding terminal electrode 68. One ends of the capacitor patterns 58a, 58b, 59a, 59b and the other ends of the shielding patterns 60a, 60b are connected to the shielding terminal electrode 69.

In this LC filter 51, as shown in Fig. 3, no magnetic field is generated between the inductor patterns 54a and 54b or between the inductor pattern 55a and 55b, that constitute each of the inductors L1, L2. Accordingly, the coupling capacitor pattern 62 that is arranged between the inductor patterns 54a, 55a and 54b, 55b rarely blocks the magnetic field H. As a result, a uniform magnetic field H is formed in the surroundings of the inductor patterns 54a, 54b and in the surroundings of the inductor patterns 55a, 55b, respectively, thereby obtaining a large inductance.

Furthermore, since the inductors L1, L2 have duplex structures, the distribution of the magnetic field H generated in the respective surroundings of the inductors L1, L2 can be optimized by adjusting the space between the inductor patterns 54a and 54b, and the space between the inductor patterns 55a and 55b, thereby making it possible to prevent the magnetic field H from being concentrated at the edges of the inductor patterns 54a to 55b. As a result, it enables a reduction in eddy current loss to be achieved.

Moreover, since the inductor patterns 54a to 55b in the respective LC resonators Q1, Q2 correspond to the capacitor patterns 58a to 59b, one-to-one, respectively, an amount of electric currents flowing into the inductor patterns 54a to 55b from the capacitor patterns 58a to 59b can be made less than the conventional one. Accordingly, it is possible to reduce the current density flowing through the inductor patterns 54a to 55b, thereby obtaining the LC filter 51 with an excellent Q characteristic.

### Second Embodiment

The second embodiment structure of the laminated LC filter according to the present invention is shown in Figs. 5 and 6. The LC filter 71 of the second embodiment is one in which capacitor patterns 72, 73 for input and output are provided, instead of the input/output lead patterns 64a, 64b, 65a, 65b, in the LC filter 51 of the first embodiment. Further, in Figs. 5 and 6, the same symbols are used to label parts corresponding to those in Figs. 1 and 2, and the redundant descriptions thereof will be omitted.

The capacitor patterns 72, 73 for input and output are provided on the ceramic sheet 52 in which the coupling capacitor pattern 62 is provided. The capacitor pattern 72 for input is opposite to the inductor patterns 54a, 54b via the sheet 52, and is capacitive-coupled to the LC resonator Q1. One end of the capacitor pattern 72 for the input is electrically connected to the input terminal electrode 66 that is exposed at the left side of the sheet 52. The capacitor pattern 73 for output is opposite to the inductor patterns 55a, 55b via the sheet 52, and is capacitive-coupled to the LC resonator Q2. One end of the capacitor pattern 73 for the output is electrically connected to the output terminal electrode 67 that is exposed at the right side of the sheet 52.

As shown in Fig. 7 in the LC filter 71 configured as described above, the coupling capacitor pattern 62 and the capacitor patterns 72, 73 for input and output are arranged between the inductor patterns 54a, 55a and 54b, 55b, in the stacking direction of the sheet 52. Accordingly, the coupling capacitor pattern 62 and the capacitor patterns 72, 73 for input and output rarely block the magnetic field H of the inductors L1, L2. As a result, a uniform magnetic field H is generated, thereby obtaining a large inductance.

### Third Embodiment

In Fig. 8, a structure of the laminated LC band pass filter 81 according to the third embodiment of the invention is shown, and in Figs. 9 and 11, a perspective view of the appearance thereof and an electrical equivalent circuit diagram are shown, respectively. As shown in Fig. 11, the LC filter 81 is a three-stage LC band pass filter, and the LC resonator Q1 of the first stage (the initial stage), the LC resonator Q2 of the second stage and the LC resonator Q3 of the third stage (the end stage) are cascade-connected (daisy-chained) via the coupling capacitors Cs1, Cs2.

As shown in Fig. 8, the LC filter 81 is constituted of two ceramic sheets 82 on the surface of which the inductor patterns 83a, 83b, 84a, 84b, 85a, 85b are provided, respectively, two ceramic sheets 82 on the surface of which the capacitor patterns 89a, 89b, 90a, 90b, 91a, 91b are provided respectively, two ceramic sheets 82 on the surface of which the shielding patterns 92a, 92b are provided respectively, two ceramic sheets 82 on the surface of which coupling capacitor patterns 93a, 93b, 94a, 94b are provided respectively, and a ceramic sheet 82 bearing a pattern 95 for adjusting a pole and the like.

The inductor patterns 83a, 83b are in the same shape, and are laminated through the sheets 82, and constitute an inductor L1 of a duplex structure. The inductor patterns 83a, 83b that are formed at the left-side locations of the sheet 82 are such that one ends thereof are exposed at an edge at the front side of the sheet 82. The other ends 86a, 86b of the inductor patterns 83a, 83b are enlarged, and these enlarged parts 86a, 86b also function as the capacitor patterns. The input lead patterns 96a, 96b that extend respectively from the central parts of the inductor patterns 83a, 83b are exposed on a left side of the respective sheet 82.

The inductor patterns 84a, 84b are in the same shape, and are laminated through the sheets 82, and constitute an inductor L2 of a duplex structure. The pattern widths of the inductor patterns 84a, 84b are set to be approximately 10 % or more wider, relative to the pattern widths of the inductor patterns 83a, 83b, 85a, 85b. The inductor patterns 84a, 84b that are formed at the central locations of the sheet 82 are such that one ends thereof are exposed at an edge at the front side of the sheet 82. The other ends 87a, 87b of the inductor patterns 84a, 84b are enlarged, and these enlarged parts 87a, 87b also function as the capacitor patterns.

The inductor patterns 85a, 85b are in the same shape, and are laminated through the sheets 82, and constitute an inductor L3 of a duplex structure. The inductor patterns 85a, 85b that are formed at the right-side locations of the sheet 82 are such that one ends thereof are exposed at an edge at the front side of the sheet 82. The other ends 88a, 88b of the inductor patterns 85a, 85b are enlarged, and these enlarged parts 88a, 88b also function as the capacitor patterns. The output lead patterns 97a, 97b that extend respectively from the central parts of the inductor patterns 85a, 85b are exposed on a right side of the respective sheets 82.

The capacitor patterns 89a, 89b are formed at the left-side locations of the respective sheets 82, and one ends thereof are exposed at an edge at the rear side of the sheet 82. In the piling-up direction of the sheets 82, an inductor L1 of a duplex structure that is constituted of the inductor patterns 83a, 83b is arranged between the capacitor patterns 89a, 89b. These capacitor patterns 89a, 89b are opposite to the enlarged parts 86a, 86b of the inductor patterns 83a, 83b, and form the capacitor C1. Then, a LC parallel resonance circuit is formed by the capacitor C1 and the inductor L1 of the duplex structure, and constitutes the LC resonator Q1 of the first stage.

The capacitor patterns 90a, 90b are formed in the central locations of the sheet 82, and one ends thereof are exposed at an edge at the rear side of the sheet 82. An inductor L2 of a duplex structure that is constituted of the inductor patterns 84a, 84b is arranged between the capacitor patterns 90a and 90b. These capacitor patterns 90a, 90b are opposite to the enlarged parts 87a, 87b of the inductor patterns 84a, 84b, and form the capacitor C2. Then, a LC parallel resonance circuit is formed by the capacitor C2 and the inductor L2 of the duplex structure, and constitutes the LC resonator Q2 of the second stage.

The capacitor patterns 91a, 91b are formed at the right-side locations of the sheet 82, and one ends thereof are exposed at an edge at a rear side of the sheet 82. An inductor L3 of a duplex structure that is constituted of the inductor patterns 85a, 85b is arranged between the capacitor patterns 91a and 91b. These capacitor patterns 91a, 91b are opposite to the enlarged parts 88a, 88b of the inductor patterns 85a, 85b, and form the capacitor C3. Then, a LC parallel resonance circuit is formed by the capacitor C3 and the inductor L3 of the duplex structure, and constitutes the LC resonator Q3 of the third stage.

The coupling capacitor patterns 93a, 93b, 94a, 94b are provided at a rear side of the sheet 82, and in the piling-up direction of the sheets 82, they are located between the inductor patterns 83a, 84a, 85a and the inductor patterns 83b, 84b, 85b. These coupling capacitor patterns 93a, 93b are opposite to the inductor patterns 83a, 83b, 84a, 84b, and form the coupling capacitor Cs1. The coupling capacitor patterns 94a, 94b are opposite to the inductor patterns 84a, 84b, 85a, 85b, and form the coupling capacitor Cs2.

A pattern 95 for adjusting a pole is arranged between the coupling capacitor patterns 93a, 94a and 93b, 94b. This pattern 95 for adjusting the pole is opposite to the coupling capacitor patterns 93a, 94a, 93b, 94b and forms a capacitance. The shielding patterns 92a, 92b with wide areas are such that one ends thereof are exposed at the front side, and the other ends thereof are exposed at the rear side, respectively.

Each sheet 82 configured as described above is piled up in sequence as shown in Fig. 8, and is made to be the laminated body 101 as shown in Fig. 9 by firing integrally. The input terminal electrode 106 and the output terminal electrode 107 are formed at the left and right ends of the laminated body 101, respectively, and the shielding electrodes 108, 109 are formed at the front and rear sides, respectively. The input lead patterns 96a, 96b are connected to the input terminal electrode 106, and the output lead patterns 97a, 97b are connected to the output terminal electrode 107. One ends of the inductor patterns 83a to 85b and one ends of the shielding patterns 92a, 92b are connected to the shielding terminal electrode 108. One ends of the capacitor patterns 89a to 91b and the other ends of the shielding patterns 92a, 92b are connected to the shielding terminal electrode 109.

This LC filter 81 produces an effect that is similar to the LC filter 51 in the first embodiment. In this LC filter 81, as shown in Fig. 10, no magnetic field is generated between the inductor patterns 83a and 83b, 84a and 84b, 85a and 85b that constitute each of the inductors L1 to L3. Accordingly, the coupling capacitor patterns 93a to 94b that are arranged between the inductor patterns 83a, 84a, 85a and 83b, 84b, 85b and the pattern 95 for adjusting the pole rarely block the magnetic field H of the inductors L1 to L3. As a result, the uniform magnetic field H is formed, thereby obtaining a large inductance.

Further, by changing the opposed areas of the pattern 95 for adjusting the pole and the coupling capacitor patterns 93a to 94b, the pole distance of the LC filter 81 can be adjusted. For example, when the opposed areas are large, the capacitance that is formed between the pattern 95 for adjusting the pole and the coupling capacitor patterns 93a to 94b becomes large, and as shown with the solid line A in Fig. 12, this produces an attenuation characteristic in which the pole distance is great. On the contrary, when the opposed areas are small, as shown with the dotted line B in Fig. 12, this produces an attenuation characteristic in which the pole distance is small.

Moreover, the inductor patterns 84a, 84b that constitute the LC resonator Q2 of the second stage located at the center of the filter 81 are widened such that the pattern widths thereof are made 10 % or more wider relative to the inductor patterns 83a, 83b, 85a, 85b that constitute the LC resonators Q1, Q3 of the first and third stages, which are located at both ends. Accordingly, the magnetic field H at the edges of the inductor patterns 84a, 84b can be relaxed. As a result, it is possible to obtain the LC filter 81 with an excellent Q characteristic.

Incidentally, the laminated LC filter according to the present invention is not limited to the embodiments described above, but may be modified in various forms within the gist thereof. For example, the LC resonators included in the laminated LC filter may be four or more. Further, the first and second embodiments described above are the examples in which the present invention is applied to the conventional laminated LC filter shown in Fig. 13, but it goes without saying that the present invention may be applied to the conventional laminated LC filter shown in Fig. 14.

Further, the embodiments described above are ones that after having piled-up the ceramic sheets on which the patterns are formed, respectively, they are fired integrally, but the invention is not limited thereto. The ceramic sheets may be ones that have been fired in advance. Moreover, the LC filter may be produced by a manufacturing method as described below. After having formed a ceramic layer with a ceramic material in a paste form by a method of printing or the like, an arbitrary pattern is formed by applying a conductive pattern material in a paste form on a surface of the ceramic layer. Then, ceramic material in paste form is applied on the above conductive pattern so as to make the ceramic layer in which the pattern is provided therein. Similarly, by applying more ceramic material in sequence, a LC filter with a laminated structure will be obtained.

As apparent from the above description, according to the present invention, since each inductor is made as a multiplex structure constituted of two or more inductor patterns in an approximately same shape, it enables to relax the magnetic field generated in the surrounding of the inductor to be concentrated on the edges of the inductor patterns. Further, the inductor patterns in the respective LC resonators correspond to the capacitor patterns at least one-to-one, so that an amount of the electric current flowing into each of the inductor patterns from the capacitor patterns become smaller than the conventional one. Accordingly, the current density flowing through the inductor patterns is reduced, thereby enabling to enhance the Q characteristics of the respective LC resonators.

Further, no magnetic field is generated between two or more inductor patterns in approximately identical shapes that constitute each of the inductors, and the coupling capacitor patterns and the capacitor patterns for input/output rarely block the magnetic field of the inductors. Accordingly, a uniform magnetic field is formed, thereby enabling to obtain a large inductance.

In preferred embodiments, three or more stages of filters are constituted by connecting at least three of the LC resonators, and the pattern widths of the inductor patterns that constitute the LC resonators located at other than both ends are made wider than the pattern widths of the inductor patterns that constitute the LC resonators located at both ends. As a result, it enables to relax the magnetic field at the edges of the inductor patterns of the LC resonators located at other than both ends, thereby obtaining a LC filter with a low loss.

Further, by laminating the patterns for a pole adjustment between the inductor patterns of the inductors, the pole position in the filter characteristic can be set freely, without blocking the magnetic field generated in the surroundings of the inductors. Accordingly, a LC filter with a high attenuation is obtained, thereby enabling to manufacture an excellent duplexer.

The invention may be embodied in other specific forms without departing from the essential characteristics thereof. The present embodiments are therefore to be considered in all respects as illustrative and not restrictive, the scope of the invention being indicated by the appended claims rather than by foregoing description and all changes which come within the meaning and range of equivalency of the claims are therefore intended to be embraced therein.

## Claims

1. A laminated LC filter, comprising:
a laminated body (51) formed by stacking a plurality of insulation layers (52), a plurality of inductor patterns (54a,b;55a,b), and a plurality of capacitor patterns (58a,b;59a,b); and
a plurality of LC resonators (Q1,Q2) constituted of a plurality of inductors (L1,L2) formed by said inductor patterns, and a plurality of capacitors in which said capacitor patterns (58a,b;59a,b) are formed to be opposite to said inductor patterns (58a,b;59a,b), at an inside of said laminated body,
wherein said inductor (L1/L2) of each LC resonator is made as a multiplex structure by laminating two or more (54a,b/55a,b) of said inductor patterns in approximately identical shapes via said insulation layers, and coupling capacitor patterns (62) for capacitive-coupling between said LC resonators are laminated between the inductor patterns of said inductors.

2. A laminated LC filter (71) according to claim 1, wherein capacitor patterns (72,73) for input/output are laminated between the inductor patterns (54a,b;55a,b) of said inductors.

3. A laminated LC filter (81) according to claim 1 or 2, wherein three or more stages of filters (Q1-Q3) are constituted by connecting at least three of the LC resonators (L1-L3), and the pattern widths of the inductor patterns (84a,b) forming the LC resonators located at other than both ends are made wider than the pattern widths of the inductor patterns (83a,b;85a,b) forming the LC resonators located at both ends.

4. A laminated LC filter (81) according to claim 1, 2 or 3, wherein patterns (95) for a pole adjustment are laminated between the inductor patterns (83a,b;84a,b;85a,b) of said inductors.
